# EUROPEAN PATENT APPLICATION

(11) **EP 0 633 478 A2**
(43) Date of publication of application: **11.01.1995**
(21) Application number: 94110382.2
(22) Date of filing: 04.07.1994
(51) Int. Cl.: G01R 31/312, G01R 31/04, H05K 13/08, G01R 1/07

(54) **Method and device for testing electronic circuit boards**

(30) Priority: 05.07.1993 IT TO930486
(71) Applicant: SPEA S.r.l. Sistemi per l'Elettronica e l'Automazione, I-10088 Volpiano (IT)
(72) Inventor: Bonaria, Luciano, I-10088 Volpiano (IT)
(74) Representative: Jorio, Paolo

(57) **Abstract**

A test method whereby an electric pulse signal is supplied to a pin (16) of an integrated circuit (8) on an electronic circuit board (6), and, by means of an electrode (27) facing the casing (11) of the integrated circuit (8), the electric field (E) produced inside the casing (11) by the pulse signal is detected. In the event the pin (16) or the bonding wire (18) is interrupted electrically, a very weak electric field (E) is detected, and a faulty connection signal generated.

## Description

The present invention relates to a method and device for testing electronic circuit boards.

Devices for testing electronic circuit boards are known which provide for testing the electrical continuity, and so detecting any faulty connections, between the pins of the integrated circuit on the board and the chip inside the integrated circuit.

Continuity is tested using the so-called "cold" technique, i.e. with no supply to the board, and by effecting measurements not necessarily related to operation of the integrated circuit (e.g. using clamping diodes connected between the pins and a ground pin, or lateral transistors connected between the pins).

The cold technique can only be applied to certain families of (e.g. digital) integrated circuits, and is not altogether reliable.

It is an object of the present invention to provide a device enabling fast, troublefree testing of circuit boards featuring any type of integrated circuit.

According to the present invention, there is provided a method and device for testing electronic circuit boards, as claimed respectively in Claims 1 and 7.

A preferred, non-limiting embodiment of the present invention will be described by way of example with reference to the accompanying drawings, in which:
Figure 1 shows a schematic electric block diagram of a test device in accordance with the teachings of the present invention;
Figure 2 shows a partially transparent view in perspective of a portion of an electronic circuit board supporting an integrated circuit;
Figure 3 shows a view in perspective of a mechanical detail of the Figure 1 device;
Figure 4 shows a view in perspective of a first variation of the Figure 3 detail;
Figure 5 shows a view in perspective of a second variation of the Figure 3 detail;
Figure 6 shows a view in perspective of a third variation of the Figure 3 detail;
Figure 7 shows a view in perspective of a fourth variation of the Figure 3 detail.

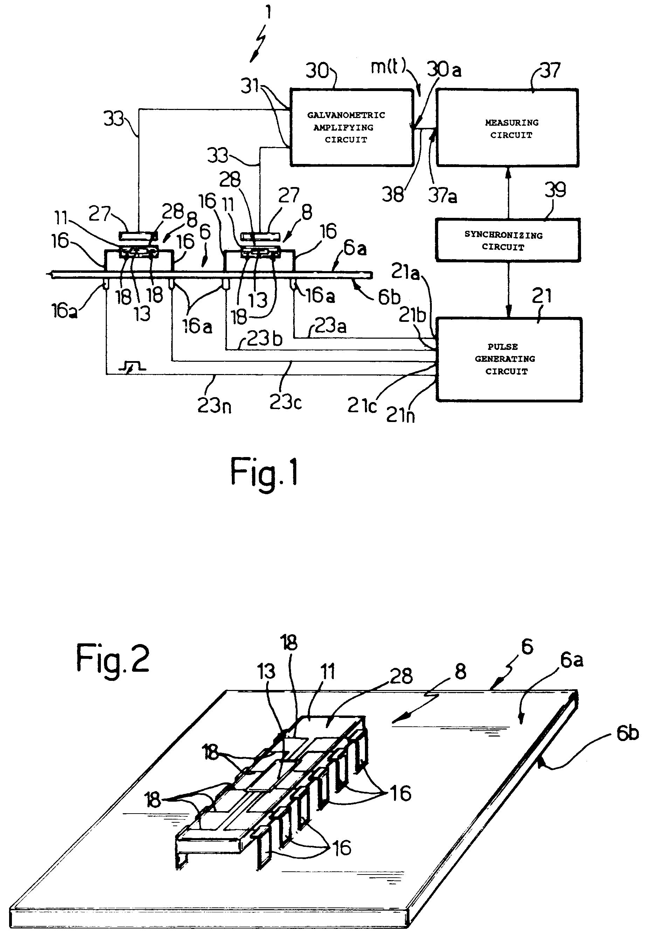

Number 1 in Figure 1 indicates a device for testing electronic circuit boards wherein a circuit board 6 supports a number of integrated circuits 8 mounted on the upper surface 6a of board 6.

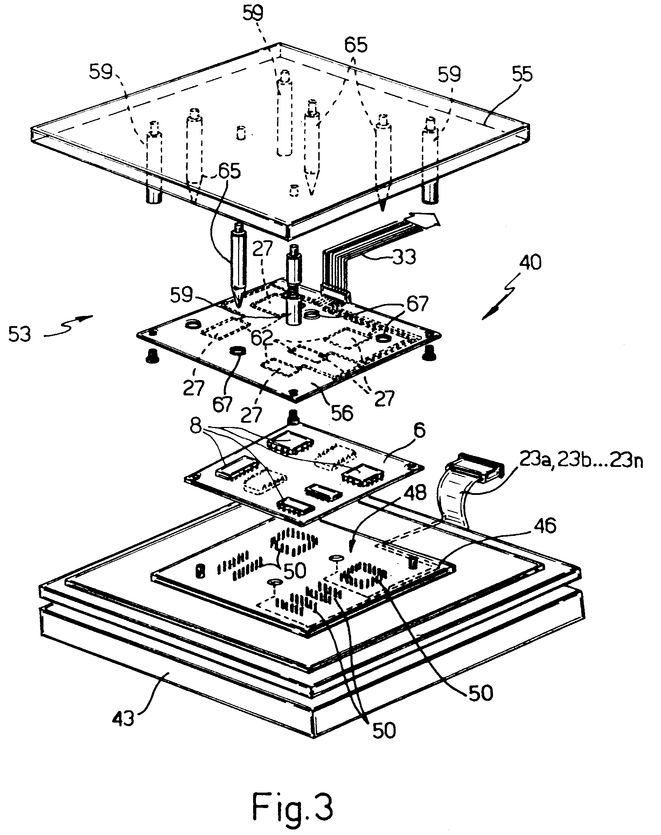

More specifically, each integrated circuit 8 (Figures 2, 3) comprises a parallelepiped plastic casing 11 housing a rectangular chip 13, and presents a number of pins 16 arranged along the two longer sides of casing 11 and connected to chip 13 by bonding wires 18 inside casing 11.

Pins 16 present respective end portions 16a housed inside through holes (not shown) in board 6 and bonded to tracks (not shown) on the lower surface 6b of board 6.

Device 1 comprises a pulse generating circuit 21 with a number of outputs 21a, 21b, ..., 21n, each connected to a respective pin 16 of integrated circuit 8 by a respective line 23a, 23b, ..., 23n.

Pulse generating circuit 21 generates a rectangular voltage pulse of about 1-2 V and a duration of about 20-50 microseconds.

The rectangular pulses are low-power (e.g. maximum 100 microjoules) to prevent damaging integrated circuits 8.

Device 1 presents a number of electrodes 27 of electrically conductive material (e.g. metal), each connected to a respective integrated circuit 8. More specifically, each electrode 27 is located on a flat rectangular surface 28 of casing 11, close to chip 13.

Device 1 also comprises a galvanometric amplifying circuit 30 presenting a number of inputs 31 connected by respective lines 33 to respective electrodes 27, and an output 30a connected by line 38 to the input 37a of a measuring circuit 37.

Measuring circuit 37 and pulse generating circuit 21 are also connected to a synchronizing circuit 39.

In actual use, the rectangular pulse produced by generating circuit 21 is supplied to a first pin 16 of integrated circuit 8, while one or more pins 16 of integrated circuit 8 are grounded by a known bypass device (not shown) in generating circuit 21.

The rectangular voltage pulse is therefore transmitted to pin 16, to bonding wire 18 connected to pin 16, and to chip 13 inside casing 11.

As such, an electric field E is generated inside casing 11 and detected by electrode 27.

Electrode 27 then supplies galvanometric amplifying circuit 30 with an electric signal related to the detected electric field E; and circuit 30 generates at the output a measuring signal m(t) proportional to the strength of electric field E.

The strength of electric field E varies according to the connection of integrated circuit 8 to board 6, and, more specifically, is extremely low if pin 16 or bonding wire 18 is interrupted, and is higher if pin 16 or bonding wire 18 presents no interruption.

The measuring signal m(t) is then compared with a threshold value Mₗᵢₘ, and, in the event the measuring signal m(t) is below threshold value Mₗᵢₘ, i.e. in the event of an interruption of pin 16 or bonding wire 18, a faulty connection signal is generated.

The above operations are repeated for all the pins of integrated circuit 8, to determine the soundness of pins 16 and all the bonding wires 18 inside casing 11.

The advantages of the device described are as follows. By virtue of the internal components of integrated circuit 8 not being used for testing, device 1 may be used for testing circuit boards featuring any type of (analog/digital) integrated circuit, regardless of its internal components or the functions performed by it.

The measurements made by device 1 are unaffected by the other electronic components connected to the integrated circuit pins on board 6.

Circuit-wise, device 1 is both straightforward and inexpensive.

By virtue of the speed with which electric field E is measured, device 1 provides for high-speed testing of the circuit boards.

And finally, using a low-power pulse signal safeguards against damaging the integrated circuits during testing.

Device 1 may be used to advantage not only for determining correct assembly of integrated circuits, but also for testing interconnection of many other - even passive - circuit board mounted electronic components, such as capacitors.

Figure 3 shows a mechanical positioning device 40 for supporting board 6 and positioning electrodes 27 contacting the casings of integrated circuits 8 on the board.

More specifically, positioning device 40 comprises a parallelepiped base 43 fitted with a (known) needle bed 46 for supporting board 6 with lower surface 6b contacting bed 46.

Needle bed 46 comprises a rectangular plate 48 of insulating material; and a number of needle conductors 50 extending through plate 48, mating with pins 16 of integrated circuits 8, and connected (in a manner not shown) to lines 23a, 23b, ..., 23n from pulse generating circuit 21.

Positioning device 40 also comprises a platen 53 composed of a rectangular upper plate 55, and a rectangular lower plate 56 parallel to and separated from upper plate 55 by four axially-compressible, straight tubular dampers 59 fitted to lower plate 56.

Lower plate 56 is positioned over parallelepiped base 43 and facing the upper surface 6a of board 6 on needle bed 46.

Lower plate 56 is moved up and down in relation to board 6 by actuators (not shown) connected to upper plate 55.

Lower plate 56 is made of insulating material (e.g. vetronite) covered with a layer of copper (or other conductive material) in which are formed grooves 62 defining a number of metal pads, each in turn defining an electrode 27.

In actual use, board 6 is placed on needle bed 46 and held pressed on to the bed by contrast fingers 65 extending from upper plate 55 to board 6 through holes 67 formed in lower plate 56.

Platen 53 is then lowered until lower plate 56 contacts casings 11 of integrated circuits 8; in which position, each metal electrode 27 is pressed on to surface 28 of a respective integrated circuit 8.

Any difference in the thickness of casings 11 of integrated circuits 8 is compensated by dampers 59.

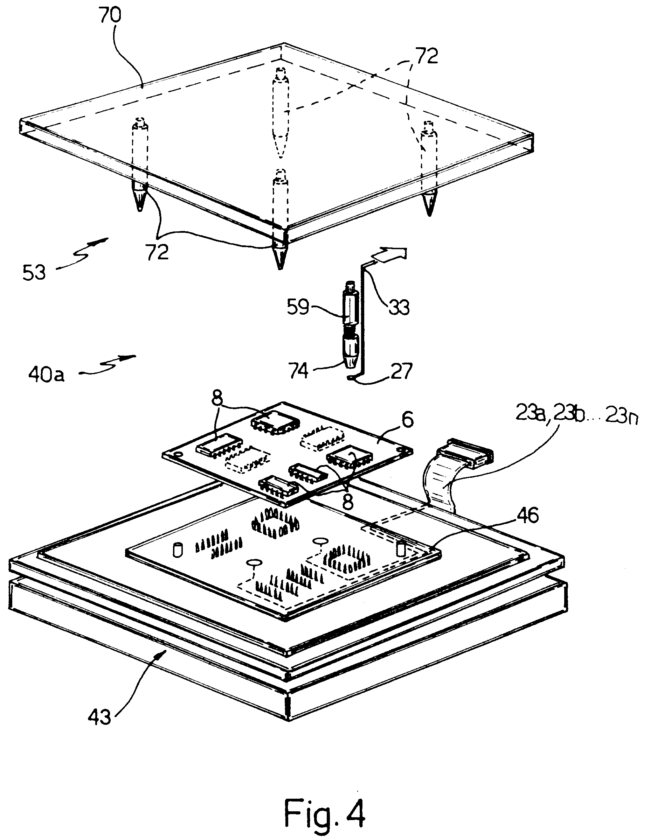

Figure 4 shows a first variation 40a of the Figure 3 positioning device from which it differs as to the design of the platen and electrodes.

The parts of variation 40a (and others described below) similar to those of device 40 are indicated using the same numbering system with no further description.

More specifically, platen 53a is composed of a rectangular plate 70, and an appropriate number (e.g. four) of cylindrical contrast fingers 72 extending perpendicularly from plate 70 towards parallelepiped base 43.

Platen 53a also comprises a number of straight tubular dampers 59 (only one shown), one for each integrated circuit 8 on board 6, extending perpendicularly from plate 70 towards parallelepiped base 43, and terminating in truncated-cone-shaped end portions 74 supporting respective (e.g. circular) metal plates defining electrodes 27.

In actual use, board 6 is placed on needle bed 46, and platen 53a is lowered until end portions 74 contact integrated circuits 8 on board 6; in which position, board 6 is held pressed on to needle bed 46 by contrast fingers 72, and each metal electrode 27 is positioned on surface 28 of a respective integrated circuit 8.

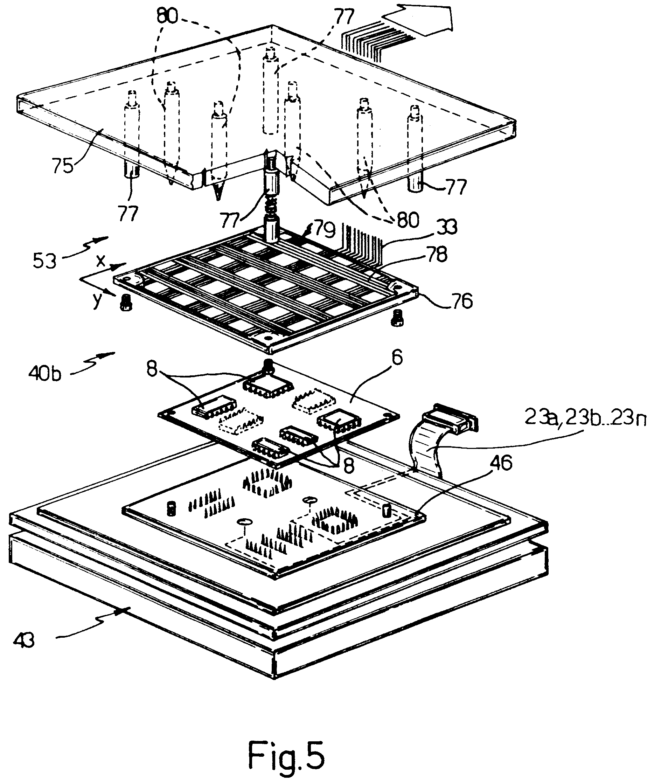

Figure 5 shows a second variation 40b of the Figure 3 positioning device from which it differs as to the design of the platen and electrodes.

More specifically, platen 53b is composed of a rectangular upper plate 75, and a rectangular lower frame 76 parallel to and separated from upper plate 75 by axially-compressible, straight tubular dampers 77 extending between corner portions of frame 76 and plate 75.

Frame 76 is positioned over parallelepiped base 43 and facing upper surface 6a of board 6 on needle bed 46.

Frame 76 supports a number of groups of insulated wires 78 extending parallel to the sides of frame 76 in two perpendicular directions (X, Y) to define a rectangular-mesh grid 79.

Plate 75 supports a number of contrast fingers 80 extending perpendicularly from plate 75 towards parallelepiped base 43 and through grid 79.

In actual use, board 6 is placed on needle bed 46, and platen 53b is lowered until the groups of wires in grid 79 contact integrated circuits 8 on board 6; in which position, board 6 is held pressed on to needle bed 46 by contrast fingers 80, and each integrated circuit is positioned facing a respective intersection between two groups of electric wires 78.

The electric field E generated in casing 11 of each integrated circuit is thus detected by two perpendicular groups of wires 78 which thus form electrode 27.

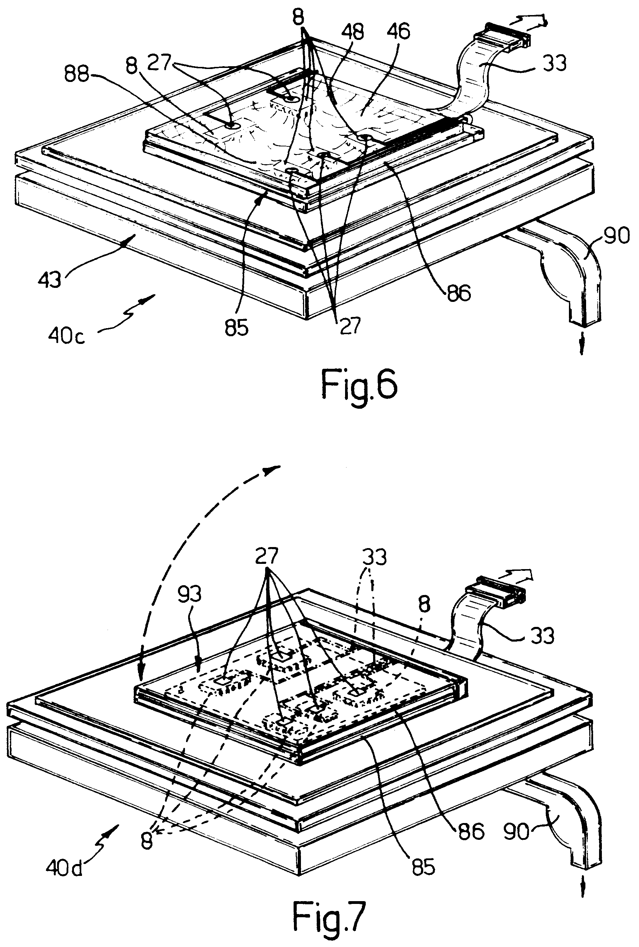

Figure 6 shows a positioning device 40c wherein the rectangular plate 48 of needle bed 46 presents a lower peripheral frame 85 hinged to a rectangular upper frame 86.

Upper frame 86 mates in fluidtight manner with frame 85, and supports a flat elastic membrane 88 to which are fitted (e.g. bonded) a number of metal blades defining electrodes 27.

In actual use, board 6 is placed on needle bed 46, and frame 86 is closed on to frame 85, so that board 6 is housed inside a chamber (not shown) defined by frames 85, 86, membrane 88, and plate 48 of needle bed 46.

By means of a vacuum pump 90 (shown schematically), a vacuum is formed inside the chamber so that board 6 adheres to needle bed 46, membrane 88 flexes inwards of the chamber to adhere to board 6, and each electrode 27 is secured stably to casing 11 of a respective integrated circuit 8.

Positioning device 40d in Figure 7 differs from device 40c by elastic membrane 88 being replaced by a rectangular plate 93 of rigid plastic material supporting electrodes 27.

In actual use, board 6 is placed on needle bed 46, and plate 93 is closed on to frame 85 so that each electrode 27 is positioned on a respective integrated circuit 8.

A vacuum is then formed by pump 90 so that board 6 adheres to needle bed 46.

Clearly, changes may be made to the test device as described and illustrated herein without, however, departing from the scope of the present invention.

## Claims

1. A method of testing electronic circuit boards (6) supporting at least one electronic component (8); characterized in that it comprises the steps of:
a) positioning at least one electrode (27) of electrically conductive material facing a portion (28) of the casing (11) of said electronic component (8);
b) supplying an electric pulse signal to at least a first pin (16) of said electronic component (8);
c) detecting, by means of said electrode (27), the electric field (E) induced by said pulse signal;
d) generating a measuring signal (m(t)) related to the strength of said electric field (E);
e) comparing said measuring signal (m(t)) with at least one threshold value (Mₗᵢₘ), for detecting connection defects.

2. A method as claimed in Claim 1, characterized in that said electric pulse signal is a rectangular voltage pulse.

3. A method as claimed in Claim 1 or 2, characterized in that said step b) of supplying an electric pulse signal to at least a first pin (16) of said electronic component comprises the step of grounding at least another pin (16) of said electronic component (8).

4. A method as claimed in any one of the foregoing Claims, characterized in that said step b) of supplying an electric pulse signal comprises the step of placing a respective contact element (50) in contact with each pin (16) of said electronic component (8), and sequentially supplying said signal to said contact elements (50).

5. A method as claimed in any one of the foregoing Claims, characterized in that said electric signal is a low-power signal.

6. A method as claimed in any one of the foregoing Claims, characterized in that said electronic component is an integrated circuit (8).

7. A device for testing electronic circuit boards (6) supporting at least one electronic component (8); characterized in that it comprises:
- generating means (21) for generating an electric pulse signal;
- connecting means (50, 23) for supplying said electric pulse signal to at least one pin (16) of said electronic component (8);
- at least one electrode (27) of electrically conductive material, which is positioned facing a portion (28) of the casing (11) of said electronic component (8), and provides for detecting the electric field (E) induced by said pulse signal;
- supporting means (40; 40a; 40b; 40c; 40d) for supporting said electrode (27);
- detecting means (30, 37) for detecting a measuring signal (m(t)) related to the strength of said electric field (E);
- comparing means (37) for comparing said measuring signal (m(t)) with at least one threshold value (Mₗᵢₘ), for detecting connection defects.

8. A device as claimed in Claim 7, characterized in that said generating means (21) produce a rectangular voltage pulse.

9. A device as claimed in Claim 7 or 8, characterized in that said supporting means (40) for supporting said electrode (27) comprise a pressure structure (53) movable in relation to a base (43) supporting said board (6);
said pressure structure (53) comprising axially-deformable elastic means (59) interposed between a movable portion (55) of said pressure structure (53) and said electrode (27).

10. A device as claimed in one of the foregoing Claims from 7 to 9, characterized in that said supporting means (40) for supporting said electrode (27) comprise at least one plate (56) on which is formed at least one metal pad defining said electrode (27).

11. A device as claimed in one of the foregoing Claims from 7 to 9, characterized in that said electrode (27) comprises a number of electric wires (78) supported on a frame (76) and intersecting one another to define a grid structure (79);
the intersecting portions of said wires (78) being positioned facing said casings (11) of said electronic components (8).

12. A device as claimed in Claim 11, characterized in that said electric wires (78) extend in two perpendicular directions (X, Y) to define a rectangular-mesh grid (79).

13. A device as claimed in Claim 7 or 8, characterized in that said electrode comprises a metal plate (27);
said supporting means (40a) for supporting said electrode (27) comprising at least one axially-deformable elastic appendix (59) presenting an end portion (74) supporting said metal plate (27).

14. A device as claimed in Claim 7 or 8, characterized in that said supporting means (40c) for supporting said electrode (27) comprise at least an elastic membrane (88) supported on a frame (86);
said frame (86) and said membrane (88) defining a chamber housing said board (6), and means (90) being provided for generating a vacuum by means of suction inside said chamber.

15. A device as claimed in Claim 7 or 8, characterized in that said supporting means (40d) for supporting said electrode (27) comprise at least a rigid plate (93);
said rigid plate (93) defining a chamber for housing said board (6), and means (90) being provided for generating a vacuum by means of suction inside said chamber.

16. A device as claimed in one of the foregoing Claims from 7 to 15, characterized in that said means (21) for generating an electric pulse signal generate a low-power signal.

17. A device as claimed in one of the foregoing Claims from 7 to 16, characterized in that said electronic component is an integrated circuit (8).
